# EUROPEAN PATENT SPECIFICATION

(11) **EP 1 547 215 B1**
(45) Date of publication and mention of the grant of the patent: **11.07.2012**
(21) Application number: 03790977.7
(22) Date of filing: 27.08.2003
(51) Int. Cl.: H01S 5/183, H01S 5/026

(54) **VERTICAL CAVITY SURFACE EMITTING LASER COMPRISING A MODULATOR MONOLITHICALLY INTEGRATED ON TOP**
OBERFLÄCHENEMITTIERENDER LASER MIT VERTIKALEM RESONATOR UND EINEM AUF DER OBERFLÄCHE ANGEORDNETEN MONOLITHISCH INTEGRIERTEN MODULATOR
LASER A EMISSION DE SURFACE A CAVITE RESONANTE VERTICALE COMPRENANT UN MODULATEUR MONOLITHIQUE FORME SUR LE DESSUS

(30) Priority: 28.08.2002 FI 20021543
(43) Date of publication of application: 29.06.2005
(73) Proprietor: Epicrystals OY, 33720 Tampere (FI)
(72) Inventor: OKHOTNIKOV, Oleg, 33820 Tampere (FI); PESSA, Markus, 33560 Tampere (FI); JOUHTI, Tomi, 00530 Helsinki (FI)
(74) Representative: Pursiainen, Timo Pekka
(86) International application number: PCT/FI2003/000623
(87) International publication number: WO 2004/021536

(56) References cited:
- EP-A2- 0 618 651
- WO-A1-01/57977
- US-A- 5 574 738
- SHIMIZU H. ET AL.: 'Nonlinear gain factor of 1,26mum GalnNas-based SQW lasers' LASERS AND ELECTRO-OPTICS, CLEO/PACIFIC RIM, 4TH PACIFIC RIM CONFERENCE vol. 2, 2001, pages II-598 - II-599, XP010567452 & DATABASE INSPEC [Online] Database accession no. 7373360

## Description

### Field of the Invention

The present invention relates to modulation of optical light using semiconductor devices with surface-normal geometry, and more specifically, to enhancement of on/off ratio, or modulation contrast of surface-normal modulators. The present invention relates to a semiconductor modulator comprising a vertical-cavity surface-emitting laser to produce a pump optical beam emitting substantially perpendicular to a surface of the laser, and a modulator element for modulating an optical signal to produce a modulated optical signal. The present invention also relates to a method for producing a semiconductor modulator comprising a vertical-cavity surface-emitting laser to produce a pump optical beam emitting substantially perpendicular to a surface of the laser, and a modulator element for modulating an optical signal to produce a modulated optical signal.

### Description of Related Art

Optical modulators are key elements in optical technology used in such systems as optical interconnect systems. There is considerable interest in surface-normal modulators for high-speed, wide-band optical signal processing and interconnection technology. One attractive solution is based on an epitaxially grown semiconductor modulator structure, consisting of multiple quantum wells with an optical mirror or mirrors to form a modulator.

In large-scale monolithic applications, where many components must be fabricated on a single wafer, it is essential to minimize the size of each component. Semiconductor surface normal modulators appear to be a promising solution because of their low power consumption and small size. Therefore, in comparison with waveguide type modulators, surface-normal modulators are most useful in applications where a fairly high density of outputs is desired. Another advantages of surface normal modulators are simplicity of the coupling of the light and fibre pigtailing and polarization insensitivity.

A major problem with surface-normal modulators is low modulation contrast and efficiency, because the interaction length with an optical beam is limited to a few micrometers. To overcome shortcomings that arise due to the short interaction length, asymmetrical Fabry-Pérot (ASFP) structures have been used in surface-normal modulators. The ASFP modulator is composed of a pair of asymmetric mirrors separated by an active layer. The use of resonant structures strongly influences the device characteristics such as achievable modulation in a cavity, spectral bandwidth, sensitivity to changing ambient temperature and optical saturation. For instance, the bandwidth of such Fabry-Pérot structures is reduced as the mirror reflectivity increases.

A variety of configurations of surface-normal modulators are being proposed to switch and modulate optical signals. Majority of the proposed surface-normal modulators are electrically-addressed devices whose operation is based on the Quantum-Confined Stark Effect (QCSE). They require the application of controlled amounts of electric field. This field is easily introduced by placing quantum wells in the intrinsic region of p-i-n diode. Several groups have realized hybrid optoelectronic ASFP devices by using the QCSE in multiple-quantum wells (MQWs). The device operation is based on the shift of excitonic absorption resonances in MQWs due to an applied electrical field. The changes in the device reflection (or transmission) then modulate the signal light. In all-optical modulator ultrashort pump pulses from the light source (possibly followed by an optical amplifier) irradiate the saturable absorber optical gate, and open it by the bleaching of the absorption. These devices use the strong non-linear absorption changes (i.e. absorption bleaching or saturation) in MQW structure, when excited optically with pump light. Signal light irradiates the same area of the device and, therefore, is encoded by the pump pulses. As a result, the data carried on the pump pulses are transferred to the signal light. Therefore, the method consists of modulating the saturable loss of the MQWs by optically pumping it above the bandgap by an external laser. This technique is attractive because it allows all-optical switching at ultrafast speed, however, it requires ultrashort pulse laser producing pump light for modulation the reflection/transmission of the optical gate.

Some of the desirable characteristics of efficient optical modulators/switches are low chirp, low operation power, large contrast ratio, and high speed. In addition, modulators should ideally have desirable optical bandwidth.

Vertical Cavity Surface Emitting Laser (VCSEL) diodes are semiconductor devices with light emission substantially perpendicular to the chip surface. They are highly attractive for applications in optoelectronics, since they offer several advantages compared to conventional edge-emitting (in-plane) laser diodes, such as low electric power consumption, capability of on-wafer testing, simplified fibre coupling and packaging, single-longitudinal-mode spectra, and suitability for 2D-array integration.

The patent US-5,574,738 discloses a GHz-range frequency-modulated laser based on manufacturable vertical cavity surface emitting lasers (VCSELs) and arrays. The laser exploits a saturable absorber contained within the VCSELs distributed Bragg reflector which may itself be adjusted during fabrication or in operation. Under controllable operating conditions, the saturable absorber will force the VCSEL to self-pulsate (in the GHz-regime) at rates related to the local intensity, absorption, lifetime, and carrier density of the saturable absorber. These conditions can be controlled in real time in one of three ways; first, by adjusting the injection current into the VCSEL itself; second, for a fixed VCSEL bias and the use of a third terminal, by modifying the carrier density within the saturable absorber via additional current injection; or third, the saturable absorber can be reverse-biased by simultaneously altering its absorption and carrier lifetime and thus carrier density. Additionally, the frequency response can be controlled in the fabrication process by affecting the location of the saturable absorber, the mirror design and cavity Q, and the laser size (and hence threshold current).

The patent publication EP 0 618 651 discloses a surface emitting laser provided with a resonator having a structure in which a quantum well structure is formed in the non-doped Distributed Bragg Reflector mirror at the opposite side to a semiconductor substrate out of a pair of Distributed Bragg Reflector mirrors sandwiching the resonator. In the quantum well structure a light absorption wavelength region is changed due to the Wannier-Stark effect or quantum-confinement Stark effect. Therefore, by applying a modulation signal for changing the electric field in the DBR mirror, the reflection loss of the DBR mirror is changed and the optical output is modulated.

Particular interest with respect to fibre-optical communication systems exists for those VCSELs that are able to emit at wavelengths around 1.31 µm or 1.55 µm because of minimum dispersion or absorption in silica fibres, respectively. Eligible material systems of compound semiconductors are (Galn)(NAs) and GalnNAsSb(GaNAsSb) on GaAs substrate and on InP there are (InGaAl)As, (InGa)(AsP) and (AlGa)(AsSb) potential for both 1.31 µm and 1.55µm emitters.

The realization of VCSELs with reasonable characteristics, however, suffers from several technological challenges related to the required materials, especially for InP-based devices in the 1.55 µm wavelength range:
- Low refractive index-contrast of Distributed Bragg Reflector (DBR) mirrors;
- Poor thermal conductivity of ternary- (quaternary-) compound semiconductor DBRs;
- Problematic light amplification performance at elevated temperatures;
- Selective Oxidation (of InAIAs) expected to cause material damage.

GaAs-based dilute nitride and antimonide alloys are seen to challenge now dominating InP-based semiconductors in the long-wavelength (1.3-1.5 µm) device markets. GaAs would offer many advantages over InP. It would be cost-effective and robust and have higher thermal conductivity than InP, and would allow for the manufacture of monolithic vertical-cavity surface-emitting lasers (VCSELs) in a single epitaxial growth run. Since the conventional InP-based material system has inherent disadvantages like poor thermal property and lack of proper mirror materials, long-wavelength laser diode constructed on GaAs substrate is highly desirable. A new material of GalnNAs, which could be realized by addition of small amount of nitrogen into GalnAs composition, is one of the best candidates for active layer of GaAs-based long-wavelength laser diodes. Due to large energy discontinuity in conduction band, the temperature characteristics of GalnNAs/Ga(AI)As quantum well is expected to be excellent. Moreover, well established GaAs/AIGaAs distributed Bragg reflectors provide enough reflectivity and conductivity for vertical-cavity surface-emitting lasers (VCSELs). Lateral confinement of carrier and optical mode by oxide layer is also applicable to improve the device performances.

The mixed group-III dilute nitrides, or substitutionally disordered Ga₁₋ₓInₓN_{y}As_{1-y} possess intriguing physical properties and great potential for applications in optoelectronics. Long-wavelength GalnNAs / GaAs lasers have already been demonstrated. The development and optimization of GaAs-based VCSELs in the near infrared region (1.3 µm -1.55 µm) includes techniques for current confinement such as blocking layers and selective oxidation, and also VCSELs with quantum dots as active material.

### Summary of the invention

It is an object of the present invention to use a laser light of the semiconductor injection laser integrated with multiple-quantum wells saturable absorber used in surface-normal configuration to modulate the reflection of the optical gate.

It is another object of the invention to improve the modulation contrast of optically pumped surface-normal modulators.

It is another object of the invention to increase the modulation efficiency of the optically pumped surface-normal modulators.

Yet another object of this invention is to enable a number of applications, for example, the application of this technology in mode-locked lasers for repetition rate stabilization, in optical signal processing, in interconnection systems, etc.

The device according to an advantageous embodiment of the invention comprises optically-controlled vertical-cavity modulator integrated monolithically with pump vertical-cavity surface-emitting laser. Molecular beam epitaxy (MBE) or metalorganic chemical vapor deposition (MOCVD) grown quantum well optoelectronic modulators in the GaInNAs / GaAs and GaInNAsSb(GaNAsSb) materials system can be used to meet the criteria for long-wavelength optical modulators.

The device according to an advantageous embodiment of the present invention comprises a reflection-type modulator with surface-normal architecture in which the signal light propagates substantially perpendicular to the surface and exploiting pump optical beam from integrated vertical-cavity surface-emitting laser (VCSEL) for modulation/switching the signal light.

The device concept exploits the integration of the surface-emitting vertical-cavity laser diode and surface-normal optical gate on the same substrate.

More precisely, the semiconductor modulator according to the present invention is primarily characterized in that the modulator element is formed integrally on top of the emitting surface of the vertical-cavity surface-emitting laser, and that the modulator element comprises a first mirror, a second mirror, and an absorber region between the first and the second mirror, wherein at least the optical transmission of the absorber region is arranged to be varied by varying the intensity of the pump optical beam, that the intensity of the pump optical beam is arranged to be varied by varying the injection current to the vertical-cavity surface-emitting laser, and said optical signal, to be intensity modulated by the modulator element, is arranged to be externally applied substantially perpendicularly to the top surface of the modulator element. The method according to the present invention is primarily characterized in that the modulator element is formed on top of the emitting surface of the vertical-cavity surface-emitting laser, in which modulator element a first mirror, a second mirror, and an absorber region between the first and the second mirror are formed, wherein the method further comprises varying the injection current to the vertical-cavity surface-emitting laser to vary the intensity of the pump optical beam which varies at least the optical transmission of the absorber region, and said optical signal, to be intensity modulated by the modulator element, is externally applied substantially perpendicularly to the top surface of the modulator element.

The present invention shows remarkable advantages over solutions of prior art. The pump VCSEL is directly modulated by modulating the injection current. Saturable absorber region is positioned on the top of the VCSEL structure and it is not affected by the injection current. Therefore, modulated laser light crosses the absorber region and modulates its transmission by saturating optically the absorption.

There is no need for external light source to pump the absorption section of the modulator.

### Brief description of the drawings

In the following, the invention will be described with reference to the appended drawings, in which
- Fig. 1: discloses in cross-sectional view an absorber region with distributed Bragg reflector of a semiconductor according to an advantageous embodiment of the present invention,
- Fig. 2: depicts a characteristic of an absorber region of a semiconductor modulator according to an advantageous embodiment of the present invention,
- Fig. 3: discloses in cross-sectional view a semiconductor modulator according to an advantageous embodiment of the present invention, and
- Fig. 4: discloses an example of a transmission system in which the semiconductor modulator of the present invention can advantageously be implemented.

### Detailed description of the invention

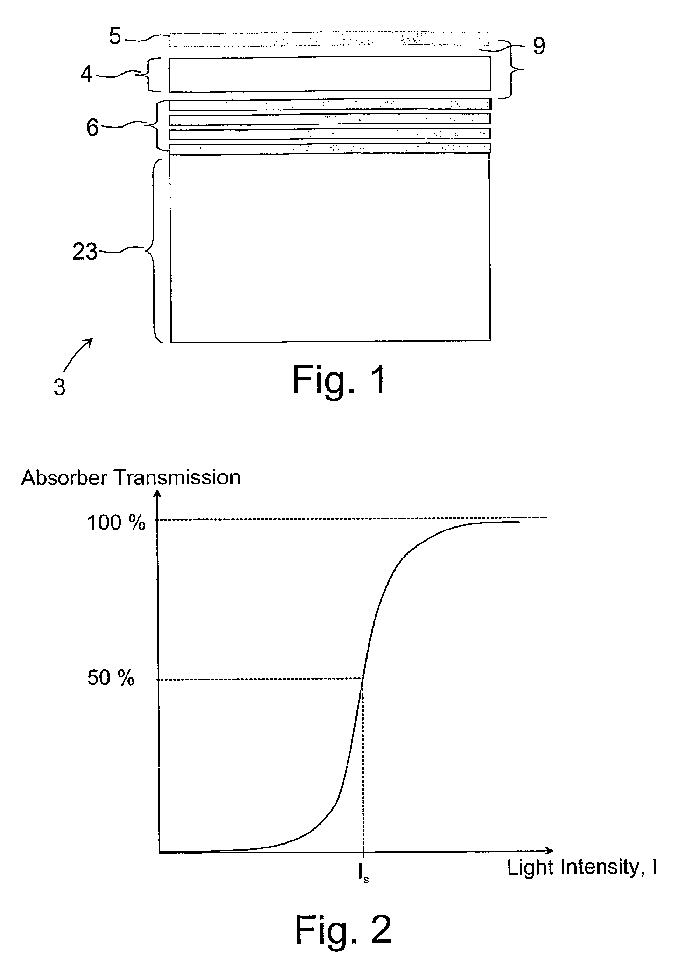

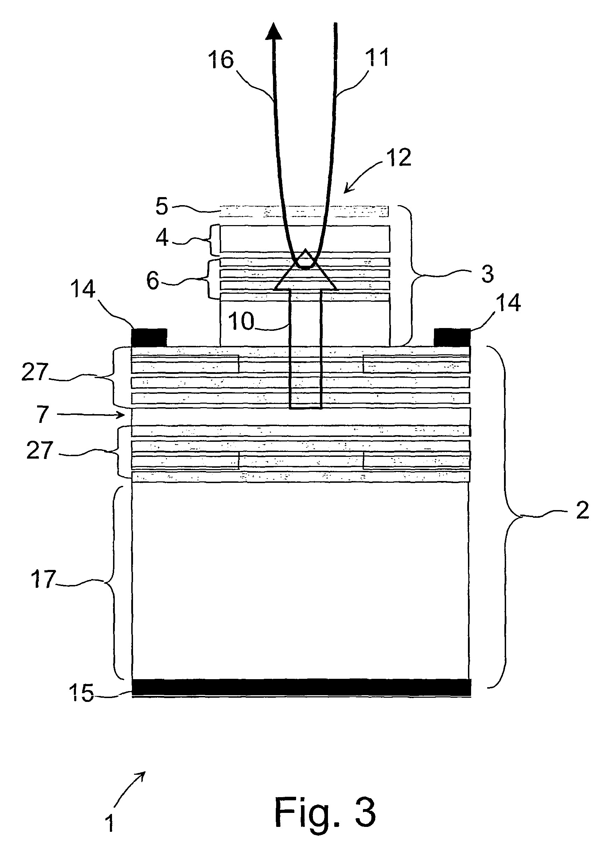

The conceptual configuration of a semiconductor modulator 1 according to an advantageous embodiment of the present invention is shown in Fig. 3. The basic parts of the semiconductor modulator 1 include a vertical-cavity surface-emitting laser 2, and a modulator element 3 comprising an absorber region 4 with top and bottom mirrors 5, 6, preferably distributed Bragg reflectors shown in Fig. 1. The absorber region 4 and the mirrors 5, 6 are preferably grown on a GaAs substrate 23.

The pump laser 2 includes semiconductor gain medium 7 comprising quantum wells and distributed Bragg reflectors (DBRs) 27 as cavity mirrors. The pump laser 2 allows for high-speed amplitude modulation of the laser beam by modulating the injection current of the laser 2.

The absorber region 4, which operates as an optical modulator, is optically connected with the laser cavity; it situates in the optical path of the output beam 10 of the laser.

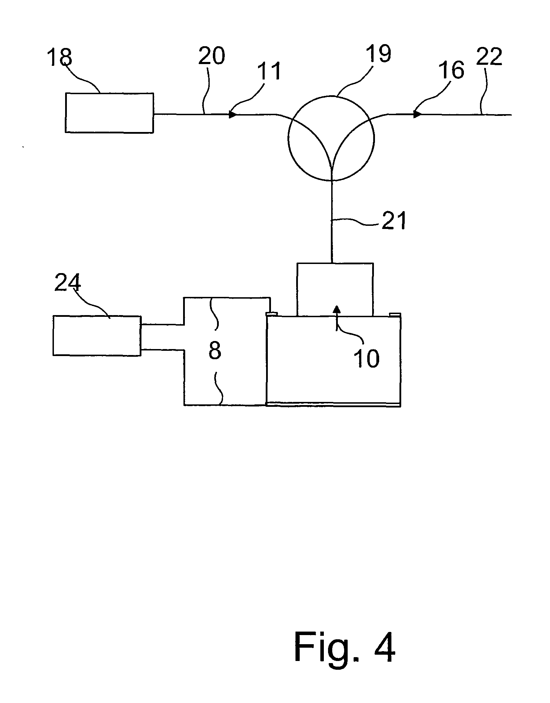

The absorption rate of the absorber region 4 can be varied by varying the intensity of the light that illuminates to the absorber region 4. The characteristic curve of the absorber region 4 is non-linear. Fig. 2 depicts an example of a characteristic curve of an absorber region 4 of a modulator 1 according to an advantageous embodiment of the present invention. The x-axis depicts the light intensity directed to the absorber region, and the γ-axis depicts the transmission rate of the absorber region as a function of the light intensity. It can be seen that at low light intensities the transmission of the absorber is low, i.e. absorption is high. The transmission increases gradually with the increase in the light intensity. With light intensities near saturation intensity of the absorber (Iₛ), the transmission rate begins to increase more rapidly with the increase in the light intensity. Eventually, at high light intensities, the absorber 4 is saturated, wherein the transmission rate is at its maximum and further increase in light intensity does not substantially affect the transmission rate. Therefore, by modulating the pump laser 2 by a modulating signal 8 generated by a modulating signal source 24 (Fig. 4) the light intensity of the pump laser 2 is changed according to changes in the modulating signal 8. When the variations in the light intensity of the pump laser 2 are selected to vary around the abrupt part of the characteristic curve, the modulation effectiveness (or contrast ratio) is very high.

The non-linearity of the quantum-well absorptive material is a function of the intensity of the incident radiation, pump wavelength, the absorption cross-section and material volume.

The saturable absorber 4 can be included as an intrinsic region, into asymmetric Fabry-Pérot (ASFP) structure to further enhance the non-linear response of the modulator 1. The ASFP saturable absorber 4 operates as a resonant or antiresonant absorber at a particular wavelength. By taking appropriate values for the reflectivity of the top reflector 5 of the ASFP, it is feasible to optimise the non-linearity and losses. The saturation intensity of a saturable absorber 4 is regulated by positioning absorber element (e.g. quantum wells) within the absorber cavity and by optimising the absorber volume (e.g. number of quantum wells).

An exemplary realization of the saturable absorber (modulation element) 3 is shown in cross-sectional view in Fig. 1. The absorber section 4, wherein said Fabry-Pérot étalon has a free spectral range and finesse that can be optimised by adjusting thickness of the spacer layer 9 (Fig. 1) and reflectivity of the top mirror 5, *e.g*. distributed Bragg reflector.

The reflectivity of the bottom mirror 6 of the absorber has ideally 100 percent reflectivity for the signal light and transparent for the VCSEL pump light. However, in practice the reflectivity is slightly less than 100 percent.

Preferably, the modulator element 3 comprises a non-linear optical element 4 pumped optically by the radiation produced by the pump laser 2.

Preferably, the modulator element 3 is monolithically integrated with the pump laser 2 using vertical cavity configuration, which makes the coupling of the laser light into the modulator region 4 be efficient. The integration improves the important figures of merit of the intensity modulators, e.g., the "on/off" ratio and the transmission in the "on" state.

The modulator comprises two optical beams: A first pump optical beam 10 carries the modulating signal in optical form for modulation/switching the signal light. A second optical beam 11 carries optical signal to be modulated; the signal light propagates substantially perpendicular to the surface of the device 1.

Preferably, the semiconductor modulator 1 induces VCSEL section 2 with a multiple quantum well design of the active region and a non-linear optical element 3 connected to the first pump optical beam 10 with surface-normal architecture in which the signal light 11, 16 propagates substantially perpendicular to the surface.

Preferably, the non-linear optical medium 4 of modulation element 3 is multiple quantum-well structure.

Preferably, the nonlinear element 3 of the modulator 1 is a surface reflection saturable absorber.

The modulator region 4 includes a stack of semiconductor layers acting as Bragg reflector for signal beam 11.

The signal wave to be modulated is injected through the input device aperture 12, passed the saturable absorber region 4 and reflected back by the Bragg reflector 6.

The VCSEL 2 is a forward-biased diode. It comprises a gain medium 7, wherein an optical axis is defined between DBR mirrors 27. An exemplary realization of the electrically pumped VCSEL is shown in cross-sectional view in Fig. 3.

It should be understood that the VCSEL structure 2 of the present invention is not limited by the design presented in the description but other electrically pumped VCSELs having different electrical contact structure and modal guiding can also be implemented in the modulator. VCSEL technology has been researched for years as an alternative and less-costly light source for use in short-distance applications. Their smaller size, lower power, lower cost, and good reliability enabled their popularity to soar over the years. Commercial VCSELs run at 850 nm, although the market also began in the 980-nm range. Examples of the electrically pumped VCSEL can be found in opened literatures (for example E. Hall et al., "Electrically-pumped, single-epitaxial VCSELs at 1.55 µm with Sb-based mirrors", Electron. Lett., vol. 35, pp. 1337-1338, 1999, or Tchang-Hun et al., "Vertical resonator surface emission laser used in optical data communications systems comprises mirror structures, a light producing region, a semiconductor section", PATENT Numbers: DE10136334, Gb2370689, JP2002094180).

Fig. 4 presents an example of an optical transmission system in which the semiconductor modulator 1 can be used for light modulation. The pump laser 2 receives an electrical pump signal and generates optical pump beam 10. The electrodes 14, 15 of the laser section is supplied with a modulating signal 8, which allows the laser section 2 to produce modulated laser emission. The modulated laser light passes through the absorber region 4 and modulates its transmission by saturating the absorption. The reflection of the modulator element 3 is increased or decreased by increasing or decreasing the intensity of the pump laser light 10. The modulator element 3 is exposed with an optical signal 11 to be modulated. This optical signal is generated by an optical signal source 18 from which the optical signal is coupled to an optical circulator 19 via an input fibre 20. The optical circulator directs the optical signal to the modulator 1 via a coupling fibre 21 for modulation. The modulated optical signal is reflected from the modulator element 3. The reflected signal acquires amplitude/intensity modulation since it is assumed that the absorption of the modulator element 3 is strongly saturated by the modulated laser light. The modulated light beam is directed back to the coupling fibre 21 in which the optical signal propagates back to the optical circulator 19. By the optical circulator 19 the modulated optical signal is directed to the output port fibre 22 for transmission.

The quantum well structures of the laser 2 and modulator element 3 have the different parameters (e.g., bandgap). Generally, if the laser 2 wavelength is shorter than the bandgap wavelength of the modulator element 3, i.e. λₚᵤₘₚ<λ_{modulator}, the laser light provides strong saturation of the absorption in the modulator element 3.

For example, for modulator operating near λ_{modulator}=1.55 µm, the pump wavelength can conveniently be chosen in a range λₚᵤₘₚ=0.9-1.3 µm.

In another aspect, the invention features a method for modulating an optical input 11, e.g., a laser beam, to provide a modulated optical output 16. First, the modulating VCSEL 2 generates a modulating beam 10 configured to strike the surface-normal saturable absorber 4. Second, a surface-normal semiconductor saturable absorber 4 is irradiated with the optical input 11. In the optically-pumped modulator, a saturation intensity Iₛ of the saturable absorber 4 and optical intensity of the integrated laser 2, can be selected such that the saturable absorber 4 is above the saturation intensity Iₛ for the "ON" state, and it is below the saturation intensity Iₛ for "OFF" state. When the modulating optical beam carriers a constant pump signal, either "ON" or "OFF", the modulator operates as an optical switch. When the modulating beam carries a modulating optical beam, the output beam 16, reflected from the modulator section substantially perpendicularly to the DBR mirror 5, is modulated according to the modulating pump beam 10. The optimum overlap of the modulating beam 10 and output modulated beam 16 is determined by the monolithic structure of the device 1 which incorporates pump laser 2 and the absorption section 4 of the surface normal modulator 3 on the same substrate 17. Therefore, the modulating laser beam overlaps in the absorber region, where the modulation of the signal beam takes place, thus providing high modulation efficiency.

In another aspect, the recovery time of the saturable absorber section 4 may be altered by using ion implantation.

The modulator section 3 is constituted by the saturable absorption section 4, and the bottom mirror (distributed Bragg reflector) 6 having a high reflectivity for a wavelength of the signal modulated light formed on the top of said vertical-cavity surface-emitting pump laser 2.

An electrically-pumped VCSEL is provided for converting an electrical signal into optical pump signal for modulation of the transmission of the modulator section in accordance with the amplitude of the converted electrical signal. In place of the optically-pumped modulator section, a non-linear reflection-type saturable absorber is used for modulation/switching the optical signal in accordance with the amplitude of the electrical signal.

The modulator section may comprise a top mirror 5 to exploit cavity effect for enhancing the modulation efficiency.

In an advantageous embodiment of the present invention the distributed Bragg reflector 6 of the modulator section 3 may be doped to conduct the injection current used for modulation of VCSEL 2.

It is obvious that the present invention is not limited solely to the above-presented embodiments, but it can be modified within the scope of the appended claims.

### References

### U.S. Patent Documents

| | | | |
|---|---|---|---|
| 5345454 | Sep., 1994 | Keller | 372/12 |
| 5548433 | Aug., 1996 | Smith | 359/158 |
| 5627854 | May., 1997 | Knox | 372/99 |
| 5828679 | Oct., 1998 | Fisher | 372/6 |
| 6081631 | Jun., 2000 | Brindel et al | 385/1 |
| 6259719 | Jul., 2001 | Cunningham et al. | 372/99 |

### Other References

G. D. Boyd et al., "5.5 GHz multiple quantum well reflection modulator", Electronics Letters, vol. 25, No. 9, pp. 558-560, 27 Apr. 1989.
M. Whitehead et al., "High-contrast reflection modulation at normal incidence in asymmetric multiple quantum well Fabry-Perot structure", Electronics Letters, vol. 25, No. 9, pp. 566-568, 27 Apr. 1989.
M. Chmielowski et al., "Quantum well vertical light modulator", IEEE Photonics Technology Letters, vol. 1, No. 4, pp. 77-79, 4 Apr. 1989.
L. R. Brovelli et al., "Antiresonant Fabry-Perot quantum-well modulator to actively modelock and synchronise solid-state lasers", Electronics Letters, vol. 31, No. 5, pp. 381-382, 2 Mar. 1995.
Hirano et al., "10 ps pulse all-optical discriminator using a high-speed saturable absorber optical gate", Electronics Letters, vol. 31, No. 9, pp. 736-737, 27 Apr. 1995.
E. Lugagne Delpon et al., "Ultrafast excitonic saturable absorption in ion-implanted InGaAs/InAlAs multiple quantum wells", Applied Physics Letters, vol. 72, No. 7, pp. 759-761, 16 Feb. 1998.
N. H. Bonadeo et al., "Passive harmonic mode-locked soliton fiber laser stabilized by an optically pumped saturable Bragg reflector", Optics Letters, vol. 25, No. 19, pp. 1421-1423, 1 Oct. 2000.
M. Whitehead, and G, Parry, "High-contrast reflection modulation at normal incidence in asymmetric multiple quantum well Fabry-Perot structure", Electron. Lett., vol. 25, No. 9, pp. 566-568, 1989.
A. Hirano, et al., "10Gbit/s RZ all-optical discrimination using refined saturable absorber optical gate", Electron. Lett., vol. 34, pp. 198-199, 1998.
H. S. Loka, et al., "Ultrafast all-optical switching in an asymmetric Fabry-Pérot device using low-temperature-grown GaAs", IEEE Photon. Technol. Lett., vol. 10, pp. 1733-1735, 1998.
J. Mangeney et al. "All-optical discrimination at 1.5 µm using ultrafast saturable absorber vertical cavity device", Electron. Lett., vol. 36, pp. 1486-1488, 2000.
J. F. Heffernan et al., "All optical, high contrast absorptive modulation in an asymmetric Fabry-Perot étalon", Appl. Phys. Lett., vol. 58, pp. 2877-2879, 1991.
N. Xiang, et al., " Broadband semiconductor saturable absorber mirror at 1.55 µm using Burstein-Moss shifted Ga0.47ln0.53As / InP distributed Bragg reflector", Electron. Lett., vol. 37, pp. 374-375, 2001.
A. Isomäki, et al., "Amplified spontaneous noise suppression using non-linear vertical-cavity semiconductor gate", in Topical Meeting on Nonlinear Optics: Materials, Fundamentals and Applications, Hawaii, (Optical Society of America, Washington, D.C., 2002), paper MC2-1, pp. 31-33.
E. Gouardes, et al., "GalnAs-GalnNAs-GalnAs intermediate layer structure for long wavelength lasers", IEEE Photon. Technol. Lett., vol. 14, pp. 896-898, 2002.
N. Tansu, et al., "Temperature sensitivity of 1300-nm InGaAsN quantum-well lasers", IEEE Photon. Technol. Lett., vol. 14, pp. 1052-1054, 2002.
R. J. Kaplar et al., "Deep-level defects in InGaAsN grown by molecular-beam epitaxy", Appl. Phys. Lett., vol. 80, pp. 4777-4779, 2002.
E. Yoshida, et al., "A 40-GHz 0.9-ps regeneratively mode-locked fiber laser with a tuning range of 1530-1560 nm", IEEE Photon. Technol. Lett, vol. 11, pp. 1587-1589, 1999.
O. G. Okhotnikov, et al., "Colliding-pulse harmonically mode-locked fiber laser", Appl. Phys. B, vol. 72, pp. 381-384, 2001.
N. Xiang, et al., "Broadband semiconductor saturable absorber mirrors in the 1.55-µm wavelength range for pulse generation in fiber lasers", IEEE J. Quantum Electron., vol. 38, pp. 369-374, 2002.
M. Guina, et al., "Harmonically mode-locked laser stabilized by semiconductor saturable absorber modulated with the residual pump", Appl. Phys. B., 74, July, 2002.

## Claims

1. A semiconductor modulator (1) comprising a vertical-cavity surface-emitting laser (2) to produce a pump optical beam (10) emitting substantially perpendicular to a surface of the laser (2), and a modulator element (3) to be driven by said pump optical beam for modulating an optical signal (11) to produce an intensity modulated optical signal (16), wherein the modulator element (3) is formed integrally on top of the emitting surface of the vertical-cavity surface-emitting laser (2), and the modulator element (3) comprises a first (5) mirror, a second mirror (6), and an absorber region (4) between the first (5) and the second mirror (6), wherein at least the optical transmission of the absorber region (4) is arranged to be varied by varying the intensity of the pump optical beam (10), the intensity of the pump optical beam (10) is arranged to be varied by varying the injection current to the vertical-cavity surface-emitting laser (2), and said optical signal (11), to be intensity modulated by the modulator element, is arranged to be externally applied substantially perpendicularly to the top surface of the modulator element (3).

2. A semiconductor modulator (1) according to claim 1, **characterized in that** the optical transmission of the modulator element (3) is nonlinearly dependent on the intensity of the pump optical beam (10).

3. A semiconductor modulator (1) according to claim 1 or 2, **characterized in that** the second mirror (6) is a Distributed Bragg Reflector mirror having a high reflectivity at the wavelength of the modulated optical signal (16).

4. A semiconductor modulator (1) according to any of claims 1 to 3, **characterized in that** the second mirror (6) of the modulator section (3) is doped to conduct the injection current used for modulation of pump laser (2).

5. A semiconductor modulator (1) according to any of claims 1 to 4, **characterized in that** the modulator element (3) comprises GalnNAs /GaAs materials.

6. A semiconductor modulator (1) according to any of claims 1 to 4, **characterized in that** the modulator element (3) comprises GalnNAsSb(GaNAsSb)/GaAs materials.

7. A semiconductor modulator (1) according to any of claims 1 to 6, **characterized in that** it is arranged to be operating at wavelengths λ>1.3 µm.

8. A semiconductor modulator (1) according to any of claims 1 to 7, **characterized in that** the first (5) mirror, the second mirror (6), and the absorber region (4) form a Fabry-Pérot étalon having a predetermined optical resonance frequency, and that the predetermined optical frequency is arranged to be occurred either at resonance or antiresonance of said Fabry-Pérot étalon.

9. A semiconductor modulator (1) according to any of claims 1 to 8, **characterized in that** the vertical-cavity surface-emitting laser (2) and the modulator element (3) are monolithically integrated onto a same substrate.

10. A method for producing a semiconductor modulator (1) comprising a vertical-cavity surface-emitting laser (2) to produce a pump optical beam (10) emitting substantially perpendicular to a surface of the laser (2), and a modulator element (3) to be driven by said pump optical beam for modulating an optical signal (11) to produce an intensity modulated optical signal (16), the wherein the modulator element (3) is formed integrally on top of the emitting surface of the vertical-cavity surface-emitting laser (2), in which modulator element (3) a first (5) mirror, a second mirror (6), and an absorber region (4) between the first (5) and the second mirror (6) are formed, wherein the method further comprises providing means for varying the injection current to the vertical-cavity surface-emitting laser (2) to vary the intensity of the pump optical beam (10) which varies at least the optical transmission of the absorber region (4), and providing means for externally applying said optical signal (11), to be intensity modulated by the modulator element, substantially perpendicularly to the top surface of the modulator element (3).

11. A method according to claim 10, **characterized in that** in the production of the modulator element (3) GainNAs / GaAs materials are used.

12. A method according to claim 10, **characterized in that** in the production of the modulator element (3) GalnNAsSb(GaNAsSb)/GaAs materials are used.

13. A method according to claim 11 or 12, **characterized in that** the speed of the absorber region (4) is controlled by controlling density of defects by selecting material composition and growth condition.

## Patentansprüche

1. Halbleitermodulator (1), aufweisend einen Vertical-Cavity Surface Emitting Laser (vertikal emittierender Laser) (2) zur Erzeugung eines optischen Pumpstrahls (10), der im Wesentlichen senkrecht zu einer Oberfläche des Lasers (2) emittiert, und ein von dem optischen Pumpstrahl anzutreibendes Modulatorelement (3) zum Modulieren eines optischen Signals (11), um ein intensitätsmoduliertes optisches Signal (16) zu erzeugen, wobei das Modulatorelement (3) in einem Stück oben auf der emittierenden Oberfläche des Vertical-Cavity Surface Emitting Laser (2) gebildet ist und das Modulatorelement (3) einen ersten (5) Spiegel, einen zweiten Spiegel (6) sowie einen Absorberbereich (4) zwischen dem ersten (5) und dem zweiten Spiegel (6) aufweist, wobei zumindest die optische Übertragung des Absorberbereichs (4) so gestaltet ist, dass sie durch Verändern der Intensität des optischen Pumpstrahls (10) verändert wird, die Intensität des optischen Pumpstrahls (10) so gestaltet ist, dass sie durch Verändern des Injektionsstroms zum Vertical-Cavity Surface Emitting Laser (2) verändert wird, und das optische Signal (11), das durch das Modulatorelement intensitätsmoduliert werden soll, so gestaltet ist, dass es im Wesentlichen senkrecht zur Oberfläche des Modulatorelements (3) außen angelegt wird.

2. Halbleitermodulator (1) nach Anspruch 1, **dadurch gekennzeichnet, dass** die optische Übertragung des Modulatorelements (3) nichtlinear von der Intensität des optischen Pumpstrahls (10) abhängt.

3. Halbleitermodulator (1) nach Anspruch 1 oder 2, **dadurch gekennzeichnet, dass** der zweite Spiegel (6) ein Bragg-Spiegel mit einem hohen Reflexionsvermögen bei der Wellenlänge des modulierten optischen Signals (16) ist.

4. Halbleitermodulator (1) nach einem der Ansprüche 1 bis 3, **dadurch gekennzeichnet, dass** der zweite Spiegel (6) des Modulatorabschnitts (3) dotiert ist, um den für die Modulation des Pumplasers (2) verwendeten Injektionsstrom zu leiten.

5. Halbleitermodulator (1) nach einem der Ansprüche 1 bis 4, **dadurch gekennzeichnet, dass** das Modulatorelement (3) GalnNAs / GaAs - Materialien aufweist.

6. Halbleitermodulator (1) nach einem der Ansprüche 1 bis 4, **dadurch gekennzeichnet, dass** das Modulatorelement (3) GalnNAsSb(GaNAsSb) / GaAs - Materialien aufweist.

7. Halbleitermodulator (1) nach einem der Ansprüche 1 bis 6, **dadurch gekennzeichnet, dass** er so gestaltet ist, dass er mit Wellenlängen von λ > 1,3 µm arbeitet.

8. Halbleitermodulator (1) nach einem der Ansprüche 1 bis 7, **dadurch gekennzeichnet, dass** der erste (5) Spiegel, der zweite Spiegel (6) und der Absorberbereich (4) ein Fabry-Perot-Etalon mit einer vorbestimmten optischen Resonanzfrequenz bilden, und dass die vorbestimmte optische Frequenz so gestaltet ist, dass sie entweder bei der Resonanz oder der Parallelresonanz des Fabry-Perot-Etalon auftritt.

9. Halbleitermodulator (1) nach einem der Ansprüche 1 bis 8, **dadurch gekennzeichnet, dass** der Vertical-Cavity Surface Emitting Laser (2) und das Modulatorelement (30) monolithisch auf einem gleichen Substrat integriert sind.

10. Verfahren zur Herstellung eines Halbleitermodulators (1), aufweisend einen Vertical-Cavity Surface Emitting Laser (2) zur Erzeugung eines optischen Pumpstrahls (10), der im Wesentlichen senkrecht zu einer Oberfläche des Lasers (2) emittiert, und ein von dem optischen Pumpstrahl anzutreibendes Modulatorelement (3) zum Modulieren eines optischen Signals (11), um ein intensitätsmoduliertes optisches Signal (16) zu erzeugen, wobei das Modulatorelement (3) in einem Stück oben auf der emittierenden Oberfläche des Vertical-Cavity Surface Emitting Laser (2) gebildet ist, wobei ein Modulatorelement (3), ein erster (5) Spiegel, ein zweiter (6) Spiegel und ein Absorberbereich (4) zwischen dem ersten (5) und dem zweiten Spiegel (6) gebildet sind, wobei das Verfahren ferner das Vorsehen von Mitteln zum Verändern des Injektionsstroms zum Vertical-Cavity Surface Emitting Laser (2), um die Intensität des optischen Pumpstrahls (10) zu verändern, der zumindest die optische Übertragung des Absorberbereichs (4) verändert, und das Vorsehen von Mitteln zum äußeren Anlegen des optischen Signals (11), das von dem Modulatorelement intensitätsmoduliert werden soll, im Wesentlichen senkrecht zur Oberfläche des Modulatorelements (3), aufweist.

11. Verfahren nach Anspruch 10, **dadurch gekennzeichnet, dass** bei der Herstellung des Modulatorelements (3) GaInNAs / GaAs - Materialien verwendet werden.

12. Verfahren nach Anspruch 10, **dadurch gekennzeichnet, dass** bei der Herstellung des Modulatorelements (3) GaInNAsSb(GaNAsSb) / GaAs - Materialien verwendet werden.

13. Verfahren nach Anspruch 11 oder 12, **dadurch gekennzeichnet, dass** die Geschwindigkeit des Absorberbereichs (4) durch Steuern der Dichte von Fehlern gesteuert wird, indem Materialzusammensetzung und Wachstumsbedingung ausgewählt werden.

## Revendications

1. Modulateur à semi-conducteur (1) comprenant un laser à émission par la surface à cavité verticale (2) pour produire un faisceau optique de pompage (10) émettant de manière essentiellement perpendiculaire à une surface du laser (2), et un élément de modulation (3) à commander par ledit faisceau optique de pompage permettant de moduler un signal optique (11) pour produire un signal optique modulé en intensité (16), l'élément de modulation (3) étant formé intégralement sur le dessus de la surface émettrice du laser à émission par la surface à cavité verticale (2), et l'élément de modulation (3) comprenant un premier miroir (5), un deuxième miroir (6) et une région absorbante (4) entre le premier (5) et le deuxième miroir (6), au moins la transmission optique de la région absorbante (4) étant adaptée pour varier en faisant varier l'intensité du faisceau optique de pompage (10), l'intensité du faisceau optique de pompage (10) étant adaptée pour varier en faisant varier le courant d'injection fourni au laser à émission par la surface à cavité verticale (2), et ledit signal optique (11), à moduler en intensité par l'élément de modulation, étant adapté pour être appliqué à l'extérieur de manière essentiellement perpendiculaire à la surface supérieure de l'élément de modulation (3).

2. Modulateur à semi-conducteur (1) selon la revendication 1, **caractérisé en ce que** la transmission optique de l'élément de modulation (3) dépend de manière non linéaire de l'intensité du faisceau optique de pompage (10).

3. Modulateur à semi-conducteur (1) selon la revendication 1 ou 2, **caractérisé en ce que** le deuxième miroir (6) est un miroir réflecteur de Bragg distribué ayant une réflectivité élevée à la longueur d'onde du signal optique modulé (16).

4. Modulateur à semi-conducteur (1) selon l'une quelconque des revendications 1 à 3, **caractérisé en ce que** le deuxième miroir (6) de la section de modulation (3) est dopé pour conduire le courant d'injection utilisé pour la modulation du laser de pompage (2).

5. Modulateur à semi-conducteur (1) selon l'une quelconque des revendications 1 à 4, **caractérisé en ce que** l'élément de modulation (3) comprend des matériaux GalnNAs/GaAs.

6. Modulateur à semi-conducteur (1) selon l'une quelconque des revendications 1 à 4, **caractérisé en ce que** l'élément de modulation (3) comprend des matériaux GaInNAsSb(GaNAsSb)/GaAs.

7. Modulateur à semi-conducteur (1) selon l'une quelconque des revendications 1 à 6, **caractérisé en ce qu'**il est adapté pour être opérationnel à des longueurs d'onde λ > 1,3 µm.

8. Modulateur à semi-conducteur (1) selon l'une quelconque des revendications 1 à 7, **caractérisé en ce que** le premier miroir (5), le deuxième miroir (6) et la région absorbante (4) forment un étalon Fabry-Pérot ayant une fréquence de résonance optique prédéterminée, et **en ce que** la fréquence optique prédéterminée est adaptée pour se produire soit à la résonance soit à l'anti-résonance dudit étalon Fabry-Pérot.

9. Modulateur à semi-conducteur (1) selon l'une quelconque des revendications 1 à 8, **caractérisé en ce que** le laser à émission par la surface à cavité verticale (2) et l'élément de modulation (3) sont intégrés de manière monolithique sur le même substrat.

10. Procédé de production d'un modulateur à semi-conducteur (1) comprenant un laser à émission par la surface à cavité verticale (2) pour produire un faisceau optique de pompage (10) émettant de manière essentiellement perpendiculaire à une surface du laser (2), et un élément de modulation (3) à commander par ledit faisceau optique de pompage permettant de moduler un signal optique (11) pour produire un signal optique modulé en intensité (16), l'élément de modulation (3) étant formé intégralement sur le dessus de la surface émettrice du laser à émission par la surface à cavité verticale (2), élément de modulation (3) dans lequel un premier miroir (5), un deuxième miroir (6) et une région absorbante (4) entre le premier (5) et le deuxième miroir (6) sont formés, le procédé comprenant en outre la fourniture d'un moyen permettant de faire varier le courant d'injection fourni au laser à émission par la surface à cavité verticale (2) pour faire varier l'intensité du faisceau optique de pompage (10) qui fait varier au moins la transmission optique de la région absorbante (4), et la fourniture d'un moyen permettant d'appliquer à l'extérieur ledit signal optique (11), à moduler en intensité par l'élément de modulation, de manière essentiellement perpendiculaire à la surface supérieure de l'élément de modulation (3).

11. Procédé selon la revendication 10, **caractérisé en ce que** dans la production de l'élément de modulation (3) des matériaux GalnNAs/GaAs sont utilisés.

12. Procédé selon la revendication 10, **caractérisé en ce que** dans la production de l'élément de modulation (3) des matériaux GalnNAsSb(GaNAsSb)/GaAs sont utilisés.

13. Procédé selon la revendication 11 ou 12, **caractérisé en ce que** la vitesse de la région absorbante (4) est contrôlée en contrôlant la densité des imperfections par la sélection de la composition matérielle et de la condition de croissance.
